# EUROPEAN PATENT SPECIFICATION

(11) **EP 4 266 490 B1**
(45) Date of publication and mention of the grant of the patent: **01.07.2026**
(21) Application number: 23166556.3
(22) Date of filing: 04.04.2023
(51) Int. Cl.: H01Q 1/22, H01Q 21/08, H10W 70/63, H10W 70/692, H10W 70/685, H10W 70/60

(54) **SEMICONDUCTOR DEVICE**
HALBLEITERANORDNUNG
DISPOSITIF SEMI-CONDUCTEUR

(30) Priority: 22.04.2022 EP 22169389
(43) Date of publication of application: 25.10.2023
(73) Proprietor: Sony Group Corporation, Tokyo 108-0075 (JP)
(72) Inventor: HOTOPAN, Ramona Cosima, 70327 Stuttgart (DE); OTT, Arndt, 70327 Stuttgart (DE)
(74) Representative: MFG Patentanwälte Meyer-Wildhagen Meggle-Freund Gerhard PartG mbB

(56) References cited:
- US-B2- 10 109 604
- GALLER THOMAS ET AL: "Glass Package for Radar MMICs Above 150 GHz", IEEE JOURNAL OF MICROWAVES, IEEE, vol. 2, no. 1, 16 November 2021 (2021-11-16), pages 97 - 107, XP011896619, DOI: 10.1109/JMW.2021.3122067
- KROHNERT KEVIN ET AL: "Versatile Hermetically Sealed Sensor Platform for High Frequency Applications", 2021 23RD EUROPEAN MICROELECTRONICS AND PACKAGING CONFERENCE & EXHIBITION (EMPC), IMAPS-EUROPE, 13 September 2021 (2021-09-13), pages 1 - 8, XP034023799, DOI: 10.23919/EMPC53418.2021.9584974
- YU TIAN ET AL: "Development of Embedded Glass Wafer Fan-Out Package With 2D Antenna Arrays for 77GHz Millimeter-wave Chip", 2020 IEEE 70TH ELECTRONIC COMPONENTS AND TECHNOLOGY CONFERENCE (ECTC), IEEE, 3 June 2020 (2020-06-03), pages 31 - 36, XP033807964, DOI: 10.1109/ECTC32862.2020.00018

## Description

### TECHNICAL FIELD

The present disclosure generally pertains to a semiconductor device for providing a radar function.

### TECHNICAL BACKGROUND

Generally, micro radars on a chip are known. Such radars may be mm-wave (millimeter wave) radars which operate in a frequency range below 100 GHz.

Research in the radar field may typically be focused onto antenna integration in an eWLB (embedded wafer level ball grid) package. A common key point for many publications may be considered as a planar antenna which uses only one redistribution layer (RDL).

Patent publication US 10,109,604 B2 describes a package for embedding one or more electronic components comprising a carrier structure with a silicon-based carrier layer, one or more electronic components embedded in one or more cavities formed in the carrier layer, and a cover structure arranged on top of the carrier structure.

The scientific publication "Glass Package for Radar MMICs Above 150 GHz" by Thomas Galler, et al., published in IEEE Journal of Microwaves, Volume 2, No. 1, January 2022, DOI 10.1109/JMW.2021.3122067, describes a sensor packaging and a transition concept for radar applications above 150 GHz based on glass material.

The scientific publication "Versatile Hermetically Sealed Sensor Platform for high Frequency Applications" by Keving Kröhnert et al., presented at the 23rd European Microeletronics and Packaging Conference and Exhibition, 13 September 2021, DOI 10.23919/EMPF53418.2021.9584974, describes a versatile hermetically sealed sensor packaging platform based on glass interposers which is applicable in industrial metrology, MEMS, photonics, life sciences and process automation application.

The scientific publication "Development of Embedded Glass Wafer Fan-Out Package With 2D Antenna Arrays for 77GHz Millimeter-wave Chip" by Tian Yu et al., published in 2020 IEEE 70th Electronic Components and Technology Conference (ECTC), 3 June 2020, DOI 10.1109/ECTC32862.2020.00018, describes a fan-out wafer level package with the size of 9.46mm* 9.77 mm for 77 GHz as an automotive radar chip with size of 5.89mm* 5.83mm, wherein the chip is developed based on embedded glass fan out technology.

Although there exist techniques for providing a radar on a chip, it is generally desirable to provide a semiconductor device for providing a radar function.

### SUMMARY

According to a first aspect, the disclosure provides a semiconductor device in accordance with independent claim 1.

Further aspects are set forth in the dependent claims, the following description and the drawings.

### BRIEF DESCRIPTION OF THE DRAWINGS

Embodiments are explained by way of example with respect to the accompanying drawings, in which:
Fig. 1 depicts a cross-section of an embodiment of a semiconductor device according to the present disclosure;
Fig. 2 depicts a schematic diagram of a MIMO radar array according to the present disclosure;
Fig. 3 depicts an embodiment of a structured glass piece serving as a basis for a glass layer according to the present disclosure;
Fig. 4 depicts a cross-section of a further embodiment of a semiconductor device according to the present disclosure in which a further glass layer is provided on top of the silicon layer;
Fig. 5 depicts a cross-section of a further embodiment of a semiconductor device according to the present disclosure in which a further antenna is provided on the further glass layer;
Fig. 6 depicts a modification of the semiconductor device of Fig. 1 in which a flexible waveguide is provided in the notch; and
Fig. 7 depicts a further embodiment of a MIMO radar array according to the present disclosure which is different from the MIMO array 10 of Fig. 2 in that the RX antennas are separated with thin walls, i.e., are each provided in a separate notch.

### DETAILED DESCRIPTION OF EMBODIMENTS

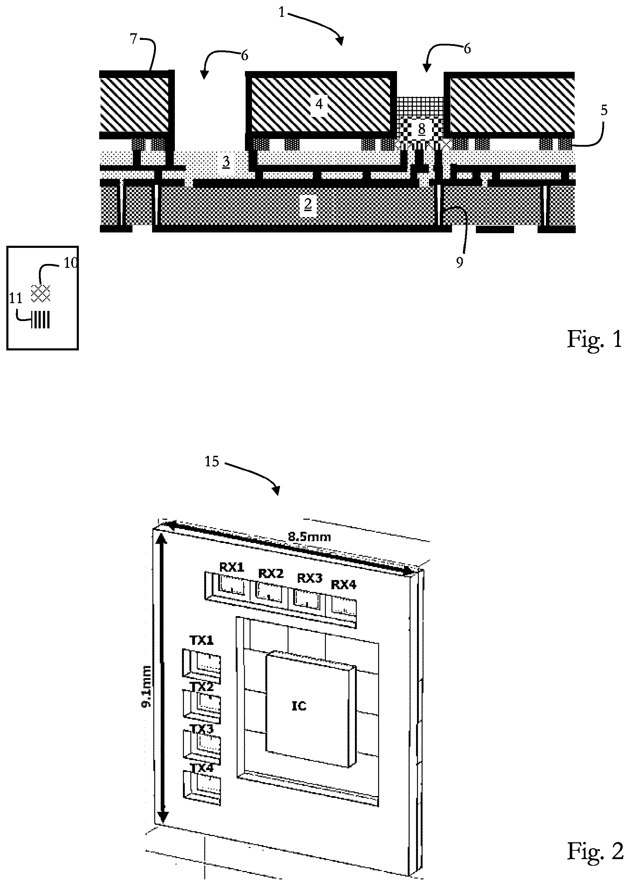

Before a detailed description of the embodiments starting with Fig. 1 is given, general explanations are made.

As mentioned in the outset micro radars on a chip are generally known.

However, highly integrated SiP (system in package) solutions for mm-wave radar systems operating in a frequency range of 100 GHz and above (e.g., up to 400 GHz (or more)) may be desirable. It has been recognized that such technology may enable low-cost, highly integrated communication devices and next generation of sensing devices, e.g., radar for gesture detection, human monitoring devices (e.g., radar based vital sign detection) and other radar-based application (e.g., in industrial applications: autonomous maneuvering).

It has further been recognized that it may be desirable to evaluate a packaging process for production not only in terms of electrical performance but also in terms of reliability, yield and cost.

In known eWLB radar devices, it has been recognized that the antenna may be covered with mold mass which may disturb a radiation pattern. Such a package may further include many edges which may cause scattering and diffraction, which may not be desired.

Such planar antenna structures may not sufficiently provide for a gain for a long range and medium range radar applications.

Moreover, performance may be limited with regard to a narrow band operation, feedline losses, radiation pattern degradations observed by mm-wave interactions withing the package.

Hence, it has been recognized that it may be desirable to integrate RF components (e.g., antennas, interconnects, IC) into a silicon-glass package and to interface to an RF chip which may also be integrated in the silicon package.

The RF signals may be routed from the RF chip to radar antennas in a silicon-based package, which may be fabricated with µm (micrometer) accuracy. It has been determined that such a configuration may result in a good performance in terms of loss and matching.

Dense signal interconnect on the package may be achieved due to a transmission line routing on a low loss glass substrate. Antennas may be arranged in a MIMO configuration (e.g., four times four) with, e.g., half wavelength spacing in air.

According to the present disclosure, different short-range applications may be supported, such as vital sign detection, gesture recognition or multiple object detection, without limiting the present disclosure in that regard.

Moreover, a high aperture efficiency and a clean radiation pattern may be obtained according to the present disclosure, which may be useful for achieving high performance radars with relatively high unambiguousness.

Therefore, the invention pertains to a semiconductor device including: a glass layer; an
insulation layer above the glass layer; and a semiconductor layer above the insulation layer, wherein at least one notch is provided in the semiconductor layer, thereby exposing the insulation layer, and wherein semiconductor material, which surrounds the at least one notch, is at least partially covered with electrically conductive material for providing a radar antenna.

The glass layer may be based on any type of glass, such as a glass ceramic, silicon-based glass, quartz glass, or the like. In some embodiments, the glass layer may be of a higher dielectric constant (than air). For example, if an antenna is provided directly on the glass layer and directly below the glass layer, the glass layer may serve the purpose of shortening the (physical) distance between the antennas compared to the distance which the antennas would need if they were provided in air. The higher the dielectric constant of the used glass is, the smaller the distance between the antennas. For example, since glass has a higher dielectric constant than air, dimensions of an antenna are reduced. For example, if a radiating structure of an antenna is (directly) placed on the glass layer and a backshort or ground of the antenna is provided below the glass layer, as described herein, the distance between the radiating part and the ground is reduced (compared to air) due to the glass material since the glass has a higher dielectric constant than air. This may lead to a reduction of a height and may optimize a form factor of the whole semiconductor device.

Moreover, an x- and y-dimension (i.e., the dimensions other than the above-described distance) may be reduced proportionally with the square root of the dielectric constant of the glass material. An area of a radiating part of the antenna may be thus reduced. For example, additional shielding vias may be placed, thereby reducing an overall coupling between the antennas. Moreover, antennas may be placed closer to each other, thereby fulfilling a "half-wavelength" criterion.

In another example, if many antennas form an array and they are placed side-by-side on a glass layer, the glass layer may serve the purpose of shortening the (physical) distance between the antennas compared to the distance which the antennas would need if they were provided in air.

Above or on the glass layer, an insulation layer may be provided which may include polyimide, polybenzoxazole (PBO), any type of organic polymer, or the like. Generally, a layer being provided "above" another layer may include a direct connection between the respective layers, but it may also be construed in that way that at least one further layer is provided between these layers.

The insulation layer may electrically insulate a wiring in the semiconductor device, or the like and/or may shield the glass layer from a semiconductor layer.

Above or on the insulation layer, the semiconductor layer may be provided. The semiconductor layer may include a semiconductor material, such as silicon, or the like.

In the semiconductor layer, at least one notch may be provided, such that the insulation layer may be exposed. "Notch" may be understood as the omission of semiconductor material, such that a hole, a hollow, a cavity, or the like, may be present. Hence, the notch may be surrounded by semiconductor material at its walls and the semiconductor material may be at least partially covered with electrically conductive material. In some embodiments, the semiconductor material may be fully covered with electrically conductive material in the notch, such that the walls of the notch may be fully surrounded by electrically conductive material.

By providing the notch (which may be partially surrounded with electrically conductive material), a radar antenna function may be provided. The radar antenna may be a primary or a secondary antenna, as will be further discussed below.

According to the invention, the semiconductor layer further includes a wiring including the electrically conductive material, wherein the wiring is partially provided below the glass layer. As discussed
above, due to the glass layer, a distance between a part of the wiring above the glass layer and the part of the wiring below the glass layer may be decreased compared to the wirings being provided in air. Moreover, a primary antenna function may be made possible.

In some embodiments, the wiring is further partially provided between the glass layer and the insulation layer, as discussed above. Still, at some areas, the insulation layer may be directly connected to the glass layer, wherein at other areas, the glass layer may be directly connected to the wiring and the wiring may be directly connected to the insulation layer.

In some embodiments, the part of wiring below the glass layer and the part of the wiring between the glass layer and the insulation layer form a micro antenna, as discussed herein.

In some embodiments, the semiconductor device further includes at least one micro-via (e.g., through-glass via) extending through the glass layer.

The at least one micro-via may be surrounded by glass of the glass layer and its wall may be metallized. The at least one micro-via may be filled with an electrically conductive material, thereby short-circuiting the wiring part above the glass layer with the wiring part below the glass layer In other words: In some embodiments, at least one micro-via is provided such that the part of the wiring below the glass layer is coupled with the part of the wiring between the glass layer and the insulation layer.

In some embodiments, the semiconductor device further includes: at least one further notch; and an integrated circuit provided in the at least one further notch which is connected to the wiring.

The integrated circuit (IC) may control the radar antenna provided in the notch with a predetermined emission frequency, or the like. For example, the IC may incorporate a function for generating radar waveforms, e.g., based on a FMCW (frequency modulated continuous waveform). Moreover, the IC may adjust phases of different output (transmit) signals for phased antenna array operation of transmit antennas. The IC may receive a radar waveform, convert the radar waveform down to a baseband, digitize baseband signals (e.g., analog to digital conversion (ADC)), process digital signals, or the like.

Further notches with further antennas (transmission and/or reception antennas) may be envisaged which may be controlled by the IC. Since the material of the wiring may also be used for the covering of the semiconductor material in the at least one notch (without limiting the present disclosure in that regard), an electric coupling of the radar antenna and the IC may be provided.

In some embodiments, the semiconductor device further includes a plurality of notches surrounded by semiconductor material, wherein the semiconductor material, which surrounds each notch of the plurality of notches, is at least partially covered with the electrically conductive material, for providing a plurality of radar antennas, as discussed herein.

In some embodiments, the semiconductor device forms a multiple input and multiple output (MIMO) radar array. According to the present disclosure, a micro antenna radar MIMO array may be provided on a small chip.

In some embodiments, a first subset of the plurality of radar antennas are transmission antennas, and wherein a second subset of the plurality of radar antennas are reception antennas, as discussed herein.

In some embodiments, the reception antennas are formed by a common notch. For example, if two reception antennas are envisaged, they may be provided directly next to each other on the insulation layer, such that a "large" notch surrounding the two reception antennas is provided.

In some embodiments, for each transmission antenna, a separate notch is provided without limiting the present disclosure in that regard.

In some embodiments, for each reception antenna, a separate notch is provided.

In some embodiments, the semiconductor device further includes a waveguide which is provided in the at least one notch in a positively locking (form-fitting) manner. The waveguide may be of a size such that a user may put it onto a target. The waveguide may have a tubular shape, for example, wherein the present disclosure is not limited to that shape. Also, the shape of the waveguide may be varying. For example, since it may be provided in a form-fitting manner, the shape may be determined by the shape of the notch. However, the shape of the waveguide may be changed in a region which is different from a notch region. The shape of the part of the waveguide which is not provided in the notch may depend on a respective application.

In some embodiments, the waveguide is provided in one notch, whereas in other embodiments, the waveguide is provided in a plurality of notches. In some embodiments, a plurality of waveguides is envisaged, wherein a subset of the waveguides is provided in one notch each and another subset of the waveguides is provided in a plurality of notches.

In some embodiments, if antennas are formed by a common notch, the waveguide may further include separation elements which, when the waveguide is input into the notches, separates the respective antennas from each other.

In some embodiments, the waveguide is based on or includes polytetrafluorethylene (PTFE), without limiting the present disclosure in that regard. In some embodiments, the waveguide may be metallized on its surface in order to prevent a leakage of waves. In some embodiments, the waveguide may consist of PTFE.

In some embodiments, the waveguide is flexible, e.g., based on a flexible material.

In some embodiments, the semiconductor device further includes a further glass layer above the semiconductor layer.

In some embodiments, the semiconductor device further includes at least one waveguide provided in the further glass layer.

According to the present disclosure, the following effects may further be present (if not already described above):
A multi-layer wafer package (Glass interposer layer with multiple redistribution layers, RDLs for antenna and RF signal lines) with vertically and horizontally stacked elements may be provided.

A size of a complex multi-channel radar system defined by antenna and passive structures may be decreased.

Dense integration due to small antenna and interconnect footprint may be achieved.

A wideband antenna integration in an SI glass package may be achieved.

A high gain antenna due to the trench edge (air waveguide topology, see below) into the Silicon; individual Si cavities (notches) for each antenna may be provided.

No or minimal interaction between the mm-wave antenna and the mm-wave due to individual cavity (or notch) placement may be present.

The highly compact antenna design may ensure that the antenna array can be arranged in a half wavelength MIMO array configuration (to support grating free antenna array operation).

An L-shape half-wavelength antenna arrangement may be provided. Any other shape may also be achieved.

The IC may be embedded in a separate cavity of the silicon-based wafer or into a glass-based interposer structure and electrically interconnected to an antenna that is located close to the IC.

Low loss interconnect and high aperture efficiency may be achieved.

It may be possible to radiate at different frequencies to cover a wider bandwidth (as also discussed below).

A higher gain than known devices may be achieved due to a glass micro-via antenna cover, placed on top of the package.

Micro via-holes in the glass cover may help not only to radiate through the substrate, but also to suppress surface waves in case of an array topology.

A number of via-holes and their positions may be designed accordingly.

Thermal Expansion Coefficient (CTE) of SI may be matched to the CTE of the bonding material resulting in increased reliability (extended life, improved yield, reduced failures, minimized stress). Generally, used materials may be adaptable to each other based on their respective CTEs.

The present disclosure may be applied to the non-limiting examples of optical cameras, security cameras, TVs, game consoles (or gaming computers), industrial sensors for distance detection, radar-based motion detection, vital sign detection, communication devices (e.g., 60 GHz short range, wireless backhaul), or the like.

Returning to Fig. 1, there is depicted a semiconductor device 1 according to the present disclosure. The different elements of the semiconductor device are emphasized with different hatchings.

The semiconductor device 1 includes a glass layer 2, an insulation layer 3 above the glass layer 2, and a semiconductor layer 4 above the insulation layer 3.

The semiconductor layer 4 is connected to the insulation layer 3 via soldering bumps 5, without limiting the present disclosure in that regard.

Fig. 1 further depicts two notches 6 in the semiconductor device 1, which are provided in the semiconductor layer 4, thereby exposing the insulation layer 3.

Moreover, a wiring 7 is provided (which is kept all in black in Fig. 1) including electrically conductive material, which covers the semiconductor material surrounding the respective notch 6, for providing a radar antenna in one of the two notches 6. In the other notch 6, an IC 8 is provided which is connected to the wiring 7.

A part of the wiring 7 is provided above the glass layer 2 and another part is provided below the glass layer 2. The two parts of the wiring 7 are coupled via micro-vias 9 (i.e., through-glass vias). The walls of the micro-vias 9 are metallized and the inner part of the micro-vias 9 includes a conductive material.

In other words, Fig. 1 shows a cross section of a silicon wafer-based package concept including a radar antenna. The IC 8 is embedded in a cavity (i.e., a notch 6) of the silicon wafer 4 for providing enough heat transfer, enabled by a heat transfer adhesive 10 (wherein for illustrational purposes, the hatching of the adhesive 10 is shown on the bottom of Fig. 1).

The silicon wafer 4 used as carrier substrate, has a low resistivity and it has a thickness of 450 µm in this embodiment, without limiting the present disclosure in that regard.

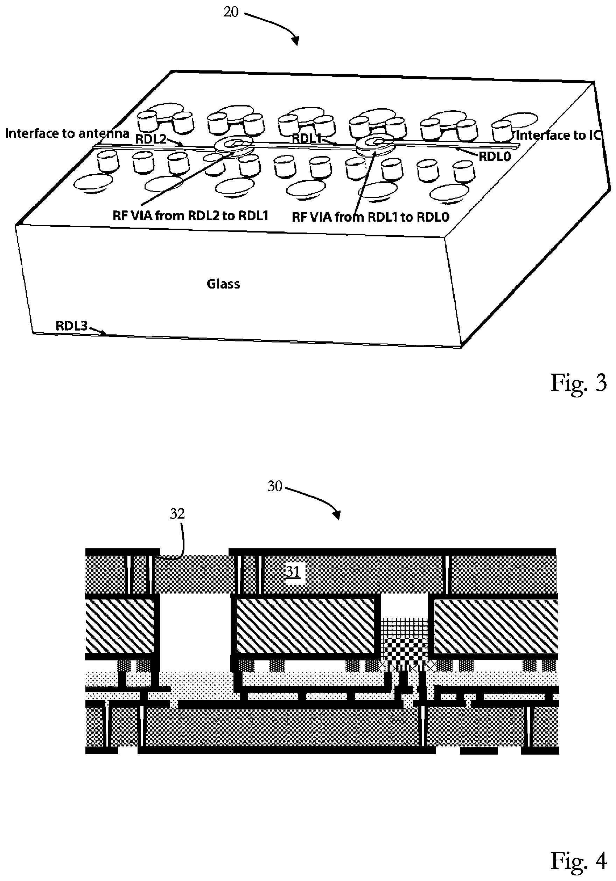

The glass interposer layer 2 with multiple redistribution layers (RDL) (as also shown in Fig. 3) is mounted below the silicon wafer. Vertical interconnects 11 (wherein for illustrational purposes, the hatching of the vertical interconnects 11 is shown on the bottom of Fig. 1) between the radar IC 8 and the fanout (the wiring 7) are achieved by (low-cost) through glass vias (TGV).

Primary patch antenna elements are printed on the RDL, and secondary antennas are formed from waveguides inside the silicon wafer. The metallized cavities (i.e., notches 6) (which are etched, in this embodiment) for the IC and antennas are bonded by a conductive material (i.e., soldered, as mentioned above, without limiting the present disclosure in that regard.). Low loss glass-based transmission lines inside the package connect the radar IC and antennas. Therefore, use of expensive high frequency substrates/laminates are eliminated.

The package (semiconductor device) may be at least partly manufactured as follows: Vias may be drilled or lasered inside a glass wafer. The glass wafer may be metallized and the vias may be filled with conductive material. Underfill material may be added at a position of the IC. The IC, including solder bumps and/or copper pillars may be placed on the glass wafer. IC and RDLs of the glass wafer may be soldered together (or connected in any other way). A silicon wafer may be soldered on top of the RDL/isolation layers of the glass wafer. The cavity/notch where the IC is placed may be filled with conductive material for ensuring a heat transfer.

Fig. 2 depicts a schematic diagram MIMO radar array 15 which is based on the semiconductor device 1 of Fig. 1. It should be noted that the depicted measures should be understood in an illustrative way and not as limiting since the MIMO radar array may actually be implemented smaller or bigger. Also, a different number of antennas and/or ICs may be envisaged. Accordingly, the notches may have different sizes, as well.

The MIMO radar array 15 includes four transmission antennas TX1, TX2, TX3, and TX4 and four reception antennas RX1, RX2, RX3, and RX4. The transmission antennas TX1 to TX4 are provided each in a separate notch, whereas the reception antennas RX1 to RX4 share a common notch.

Moreover, an IC is depicted which is connected to an internal wiring (not depicted), as discussed herein.

In this embodiment, phase centers of respective radiating elements are positioned half-wavelength apart from each other to avoid grating lobes in a radiation pattern. For isolating the RX antennas from the TX antennas, they are placed one wavelength apart from each other. The RX antennas are oriented in x-direction and the TX antennas are oriented in y-direction (x and y-axes being perpendicular to each other).

A primary antenna includes a patch which is surrounded by a metal printed on RDL 2 (see Fig. 3). The antenna is fed by a conductor backed CPW (coplanar waveguide). RDL3 (see. Fig. 3) acts as a reflector for the patch antenna. On top of the primary patch, on RDL1 (see Fig. 3), an aperture is provided. Inside the silicon wafer 4, the notch is etched and used as a secondary antenna (also referred to as "air-filled waveguide"), which may improve a radiation performance. The air-filled waveguide is positioned on top of the patch antenna metal frame. Ground connections of the layer is achieved by via fences (see Fig. 3).

According to the present embodiment, a bandwidth wider than 6 GHz may be provided.

Fig. 3 depicts a structured glass piece 20 according to the present disclosure. The structured glass piece 20 is produced such that it provides an interface to a corresponding wiring, insulation layer, semiconductor layer, and antennas, as discussed herein.

The structured glass piece 20 includes an interface to an IC and an interface to at least one radar antenna. Moreover, different RDLs (redistribution layers) are depicted which are respectively coupled via RF (radio frequency) vias.

Fig. 4 depicts a further embodiment of a semiconductor device 30 according to the present disclosure. The semiconductor device 30 is different from the semiconductor device 1 of Fig. 1 in that a further glass layer 31 is provided above the semiconductor layer 4. The wiring 7 extends above the further glass layer 31. The wiring 7 below the further glass layer 31 and above the further glass layer 31 are further coupled with micro-vias 32, thereby forming an SIW (substrate integrated waveguide) random antenna.

The SIW random antenna is coupled to the primary patch antenna in the semiconductor device. The SIW random antenna may radiate in a different (or in the same) frequency than the primary antenna, thereby covering a wider bandwidth.

The embodiment of Fig. 4 may further provide a shielding mechanism and a protection of the wafer package.

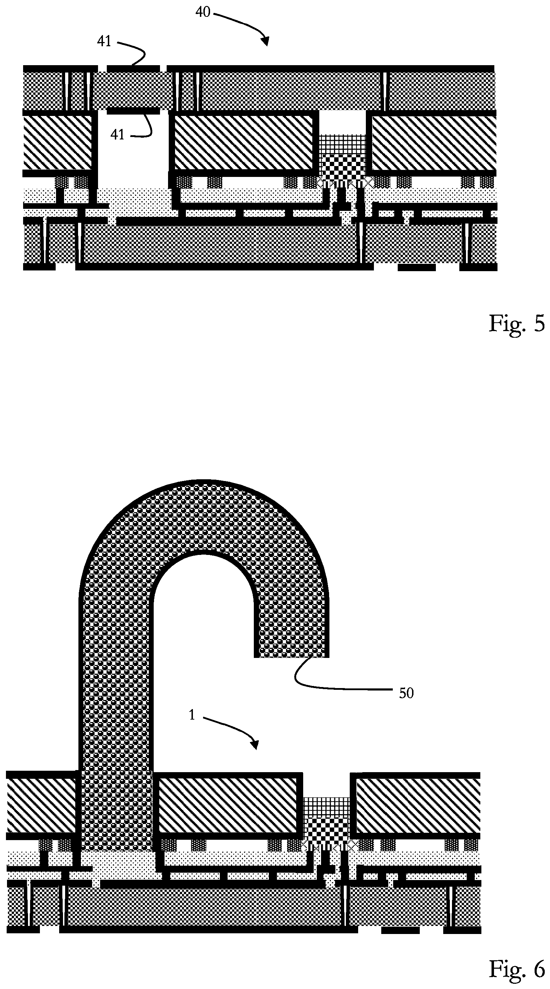

Fig. 5 depicts a further embodiment of a semiconductor device 40 according to the present disclosure which is different from the semiconductor device 30 of Fig. 4 in that antennas 41 are provided above and below the part of the glass layer 31 covering the notch. Due to the provision of the antennas 41, a higher bandwidth and a higher gain may be provided to the overall system (i.e., the semiconductor device).

Fig. 6 depicts a modification of the semiconductor device 1 of Fig. 1 in which a flexible waveguide 50 is provided in a positively locking manner in the radar antenna notch. The waveguide 50 is based on PTFE (polytetrafluorethylene) which is covered with the conductive material of the wiring 7.

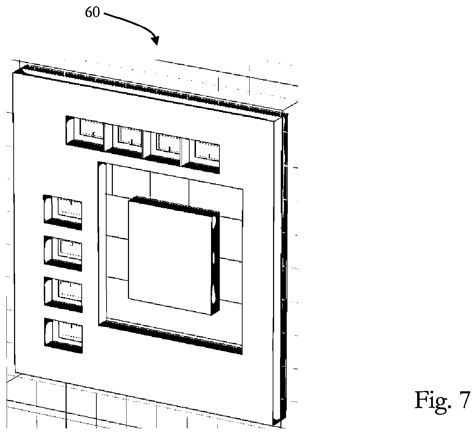

Fig. 7 depicts a further embodiment of a MIMO radar array 60 according to the present disclosure which is different from the MIMO array 15 of Fig. 2 in that the RX antennas are separated with thin walls, i.e., are each provided in a separate notch.

## Claims

1. A semiconductor device comprising:
a glass layer (2);
an insulation layer (3) above the glass layer (2); and
a semiconductor layer (4) above the insulation layer (3), wherein
at least one notch (6) is provided in the semiconductor layer (4), thereby exposing the insulation layer (3), and wherein
semiconductor material, which surrounds the at least one notch (6), is at least partially covered with electrically conductive material for providing a radar antenna
the semiconductor device further comprising a wiring (7) including the electrically conductive material, which is partially provided below the glass layer (2).

2. The semiconductor device of claim **1,** wherein the wiring (7) is further partially provided between the glass layer (2) and the insulation layer (3).

3. The semiconductor device of claim 2, wherein the part of wiring (7) below the glass layer (2) and the part of the wiring (7) between the glass layer and the insulation layer (3) form a micro antenna; and/or
wherein the semiconductor device further comprises at least one micro-via (9) extending through the glass layer (2).

4. The semiconductor device of claim 3, wherein the at least one micro-via (9) is provided such that the part of the wiring (7) below the glass layer (2) is coupled with the part of the wiring (7) between the glass layer (2) and the insulation layer (3).

5. The semiconductor device of anyone of claims 1 to 4, further comprising:
at least one further notch (6); and
an integrated circuit (8) provided in the at least one further notch (6) which is connected to the wiring (7).

6. The semiconductor device of anyone of claims 1 to 5, comprising a plurality of notches (6) surrounded by semiconductor material, wherein the semiconductor material, which surrounds each notch (6) of the plurality of notches (6), is at least partially covered with the electrically conductive material for providing a plurality of radar antennas.

7. The semiconductor device of claim 6, wherein the semiconductor device forms a multiple input and multiple output, MIMO, radar array (15); and/or
wherein a first subset of the plurality of radar antennas are transmission antennas (TX1, TX2, TX3, TX4), and wherein a second subset of the plurality of radar antennas are reception antennas (RX1, RX2, RX3, RX4).

8. The semiconductor device of claim 7, wherein the reception antennas (RX1, RX2, RX3, RX4) are formed by a common notch (6).

9. The semiconductor device of claim 7 or 8, wherein for each transmission antenna (TX1, TX2, TX3, TX4), a separate notch (6) is provided.

10. The semiconductor device of claim 7 or 9 when not dependent on claim 8, wherein for each reception antenna (RX1, RX2, RX3, RX4), a separate notch (6) is provided.

11. The semiconductor device of anyone of claims 1 to 10, further comprising a waveguide (50) which is provided in the at least one notch (6) in a positively locking manner.

12. The semiconductor device of claim 11, wherein the waveguide (50) is provided in one notch (6); and/or
wherein the waveguide (50) is provided in a plurality of notches (6); and/or
wherein the waveguide (50) is based on polytetrafluorethylene; and/or
wherein the waveguide (50) is flexible.

13. The semiconductor device of anyone of claims 1 to 12, further comprising a further glass layer (31) above the semiconductor layer (4).

14. The semiconductor device of claim 13, further comprising at least one waveguide (50) provided in the further glass layer (31).

## Patentansprüche

1. Halbleitervorrichtung, umfassend:
eine Glasschicht (2);
eine Isolationsschicht (3) oberhalb der Glasschicht (2); und
eine Halbleiterschicht (4) über der Isolationsschicht (3), wobei
mindestens eine Kerbe (6) in der Halbleiterschicht (4) bereitgestellt ist, wodurch die Isolationsschicht (3) freigelegt wird, und wobei
Halbleitermaterial, das die mindestens eine Kerbe (6) umgibt, mindestens teilweise mit elektrisch leitfähigem Material bedeckt ist, zum Bereitstellen einer Radarantenne
die Halbleitervorrichtung ferner umfassend eine Verdrahtung (7), die das elektrisch leitfähige Material einschließt, das teilweise unterhalb der Glasschicht (2) bereitgestellt ist.

2. Halbleitervorrichtung nach Anspruch 1, wobei die Verdrahtung (7) ferner teilweise zwischen der Glasschicht (2) und der Isolationsschicht (3) bereitgestellt ist.

3. Halbleitervorrichtung nach Anspruch 2, wobei der Teil der Verdrahtung (7) unterhalb der Glasschicht (2) und der Teil der Verdrahtung (7) zwischen der Glasschicht und der Isolationsschicht (3) eine Mikroantenne ausbilden; und/oder
wobei die Halbleitervorrichtung ferner mindestens eine Mikrodurchkontaktierung (9) umfasst, die sich durch die Glasschicht (2) erstreckt.

4. Halbleitervorrichtung nach Anspruch 3, wobei die mindestens eine Mikrodurchkontaktierung (9) derart bereitgestellt ist, dass der Teil der Verdrahtung (7) unterhalb der Glasschicht (2) mit dem Teil der Verdrahtung (7) zwischen der Glasschicht (2) und der Isolationsschicht (3) gekoppelt ist.

5. Halbleitervorrichtung nach einem der Ansprüche 1 bis 4, ferner umfassend:
mindestens eine weitere Kerbe (6); und
eine integrierte Schaltung (8), die in der mindestens einen weiteren Kerbe (6) bereitgestellt ist, die mit der Verdrahtung (7) verbunden ist.

6. Halbleitervorrichtung nach einem der Ansprüche 1 bis 5, umfassend eine Vielzahl von Kerben (6), die von Halbleitermaterial umgeben sind, wobei das Halbleitermaterial, das jede Kerbe (6) der Vielzahl von Kerben (6) umgibt, mindestens teilweise mit dem elektrisch leitfähigen Material bedeckt ist, um eine Vielzahl von Radarantennen bereitzustellen.

7. Halbleitervorrichtung nach Anspruch 6, wobei die Halbleitervorrichtung eine Radaranordnung (15) mit mehreren Eingängen und mehreren Ausgängen, MIMO, ausbildet; und/oder
wobei eine erste Teilmenge der Vielzahl von Radarantennen Sendeantennen (TX1, TX2, TX3, TX4) sind, und wobei eine zweite Teilmenge der Vielzahl von Radarantennen Empfangsantennen (RX1, RX2, RX3, RX4) sind.

8. Halbleitervorrichtung nach Anspruch 7, wobei die Empfangsantennen (RX1, RX2, RX3,RX4) durch eine gemeinsame Kerbe (6) ausgebildet sind.

9. Halbleitervorrichtung nach Anspruch 7 oder 8, wobei für jede Sendeantenne (TX1, TX2, TX3, TX4) eine separate Kerbe (6) bereitgestellt ist.

10. Halbleitervorrichtung nach Anspruch 7 oder 9, wenn nicht abhängig von Anspruch 8, wobei für jede Empfangsantenne (RX1, RX2, RX3, RX4) eine separate Kerbe (6) bereitgestellt ist.

11. Halbleitervorrichtung nach einem der Ansprüche 1 bis 10, ferner umfassend einen Wellenleiter (50), der in der mindestens einen Kerbe (6) formschlüssig bereitgestellt ist.

12. Halbleitervorrichtung nach Anspruch 11, wobei der Wellenleiter (50) in einer Kerbe (6) bereitgestellt ist; und/oder
wobei der Wellenleiter (50) in einer Vielzahl von Kerben (6) bereitgestellt ist; und/oder
wobei der Wellenleiter (50) auf Polytetrafluorethylen basiert; und/oder
wobei der Wellenleiter (50) flexibel ist.

13. Halbleitervorrichtung nach einem der Ansprüche 1 bis 12, ferner umfassend eine weitere Glasschicht (31) oberhalb der Halbleiterschicht (4).

14. Halbleitervorrichtung nach Anspruch 13, ferner umfassend mindestens einen Wellenleiter (50), der in der weiteren Glasschicht (31) bereitgestellt ist.

## Revendications

1. Dispositif à semi-conducteur comprenant :
une couche de verre (2) ;
une couche d'isolation (3) au-dessus de la couche de verre (2) ; et
une couche de semi-conducteur (4) au-dessus de la couche d'isolation (3), dans lequel
au moins une encoche (6) est pourvue dans la couche de semi-conducteur (4), exposant ainsi la couche d'isolation (3), et dans lequel
du matériau semi-conducteur, qui entoure l'au moins une encoche (6), est au moins partiellement recouvert d'un matériau électriquement conducteur pour fournir une antenne radar
le dispositif à semi-conducteur comprenant en outre un câblage (7) comportant le matériau électriquement conducteur, qui est partiellement pourvu au-dessous de la couche de verre (2).

2. Dispositif à semi-conducteur selon la revendication 1, dans lequel le câblage (7) est en outre partiellement pourvu entre la couche de verre (2) et la couche d'isolation (3).

3. Dispositif à semi-conducteur selon la revendication 2, dans lequel la partie de câblage (7) au-dessous de la couche de verre (2) et la partie du câblage (7) entre la couche de verre et la couche d'isolation (3) forment une micro-antenne ; et/ou
dans lequel le dispositif à semi-conducteur comprend en outre au moins un micro-trou d'interconnexion (9) s'étendant à travers la couche de verre (2).

4. Dispositif à semi-conducteur selon la revendication 3, dans lequel l'au moins un micro-trou d'interconnexion (9) est pourvu de telle sorte que la partie du câblage (7) au-dessous de la couche de verre (2) est accouplée à la partie du câblage (7) entre la couche de verre (2) et la couche d'isolation (3).

5. Dispositif à semi-conducteur selon l'une quelconque des revendications 1 à 4, comprenant en outre :
au moins une encoche supplémentaire (6) ; et
un circuit intégré (8) pourvu dans l'au moins une encoche supplémentaire (6) qui est reliée au câblage (7).

6. Dispositif à semi-conducteur selon l'une quelconque des revendications 1 à 5, comprenant une pluralité d'encoches (6) entourées par un matériau semi-conducteur, dans lequel le matériau semi-conducteur, qui entoure chaque encoche (6) de la pluralité d'encoches (6), est au moins partiellement recouvert par le matériau électriquement conducteur pour fournir une pluralité d'antennes radar.

7. Dispositif à semi-conducteur selon la revendication 6, dans lequel le dispositif à semi-conducteur forme un réseau radar à entrées multiples et sorties multiples, MIMO (15) ; et/ou
dans lequel un premier sous-ensemble de la pluralité d'antennes radar sont des antennes d'émission (TX1, TX2, TX3, TX4), et dans lequel un second sous-ensemble de la pluralité d'antennes radar sont des antennes de réception (RX1, RX2, RX3, RX4).

8. Dispositif à semi-conducteur selon la revendication 7, dans lequel les antennes de réception (RX1, RX2, RX3, RX4) sont formées par une encoche (6) commune.

9. Dispositif à semi-conducteur selon la revendication 7 ou 8, dans lequel pour chaque antenne d'émission (TX1, TX2, TX3, TX4), une encoche (6) séparée est pourvue.

10. Dispositif à semi-conducteur selon la revendication 7 ou 9 lorsqu'elle ne dépend pas de la revendication 8, dans lequel pour chaque antenne de réception (RX1, RX2, RX3, RX4), une encoche (6) séparée est pourvue.

11. Dispositif à semi-conducteur selon l'une quelconque des revendications 1 à 10, comprenant en outre un guide d'ondes (50) qui est pourvu dans l'au moins une encoche (6) par complémentarité de forme.

12. Dispositif à semi-conducteur selon la revendication 11, dans lequel le guide d'ondes (50) est pourvu dans une encoche (6) ; et/ou
dans lequel le guide d'ondes (50) est pourvu dans une une pluralité d'encoches (6) ; et/ou
dans lequel le guide d'ondes (50) est à base de polytétrafluoroéthylène ; et/ou
dans lequel le guide d'ondes (50) est flexible.

13. Dispositif à semi-conducteur selon l'une quelconque des revendications 1 à 12, comprenant en outre une couche de verre supplémentaire (31) au-dessus de la couche de semi-conducteur (4).

14. Dispositif à semi-conducteur selon la revendication 13, comprenant en outre au moins un guide d'ondes (50) pourvu dans la couche de verre supplémentaire (31).
